# EUROPEAN PATENT APPLICATION

(11) **EP 4 539 286 A1**
(43) Date of publication of application: **16.04.2025**
(21) Application number: 22949809.2
(22) Date of filing: 06.07.2022
(51) Int. Cl.: H02H 9/04, H01L 27/02

(54) **INPUT/OUTPUT INTERFACE, SIGNAL AMPLIFIER, AND INTEGRATED CIRCUIT**

(71) Applicant: Huawei Technologies Co., Ltd., Shenzhen, Guangdong 518129 (CN)
(72) Inventor: WANG, Banglin, Shenzhen, Guangdong 518129 (CN); ZHOU, Quan, Shenzhen, Guangdong 518129 (CN); FAN, Jinhan, Shenzhen, Guangdong 518129 (CN)
(74) Representative: Isarpatent
(86) International application number: PCT/CN2022/104237
(87) International publication number: WO 2024/007223

(57) **Abstract**

An input/output interface (100) is provided, including an I/O terminal, a gate component (110), and an anti-electrostatic discharge apparatus. The gate component (110) is configured to control reading of data from the I/O terminal. The gate component (110) includes a first switch component (112), where an input end of the first switch component (112) is connected to the I/O terminal. The anti-electrostatic discharge apparatus is configured to increase a breakdown voltage at the first switch component (112).

## Description

### TECHNICAL FIELD

The present disclosure generally relates to an input/output (input/output, I/O) interface, and in particular, to an I/O interface with improved anti-electrostatic discharge performance.

### BACKGROUND

An input/output interface of a device can read and write data. However, the input/output interface also faces a problem of electrostatic discharge. For example, with continuous evolution of a MOS process, a withstand voltage of a gate oxide layer of a MOS component is continuously reduced, and a requirement on an electrostatic discharge (electrostatic discharge, ESD) protection design is increasingly high. In some cases, for example, for a fin MOS component, a gate oxide layer of the MOS component of a chip is reduced to 0.8 V. This leads to a great difficulty in electrostatic discharge on an interface of the device. A conventional electrostatic discharge measure increases a risk of damage to internal components of the device.

### SUMMARY

The present disclosure provides an input/output interface, a signal amplifier, and an integrated circuit to resolve or mitigate one or more of the foregoing problems.

According to a first aspect of the present disclosure, an input/output I/O interface is provided, including: an I/O terminal; and a gate component, configured to control reading of data from the I/O terminal, and including: a first switch component, where an input end of the first switch component is connected to the I/O terminal; and an anti-electrostatic discharge apparatus, configured to increase a breakdown voltage at the first switch component. According to the I/O interface in embodiments of the present disclosure, the anti-electrostatic discharge apparatus is provided, so that the breakdown voltage at the first switch component can be increased, thereby enhancing a capability of the first switch component to withstand an electrostatic discharge breakdown voltage of the I/O terminal, and significantly improving an electrostatic discharge protection capability of the gate component.

In some embodiments, the input end of the first switch component may be directly connected to the I/O terminal. In this way, because no resistive component or the like is disposed between the input end of the first switch component and the I/O terminal, noise performance of the I/O interface is significantly improved.

In some embodiments, the anti-electrostatic discharge apparatus may include a second switch component, and an output end of the second switch component is connected to a gate electrode of the first switch component. Therefore, the second switch component is disposed, so that an electrostatic discharge protection capability of the gate component may be improved. In addition, because the anti-electrostatic discharge apparatus is implemented by using the second switch component, an on/off state of the first switch component may be conveniently controlled.

In some embodiments, the gate component may further include a phase inverter connected to an input end of the second switch component. In this way, the phase inverter may conveniently and flexibly control on and off of the first switch component based on a requirement.

In some embodiments, a gate electrode of the second switch component and an input end of the phase inverter may be synchronously controlled. Therefore, the on/off state of the first switch component may be conveniently implemented through synchronous control.

In some embodiments, the first switch component and the second switch component each may include a MOS FET.

In some embodiments, the first switch component may include a MOS transistor, and the input end includes a source electrode or a drain electrode of the MOS transistor.

In some embodiments, the second switch component may include a MOS transistor, and the output end includes a source electrode or a drain electrode of the MOS transistor.

In some embodiments, the I/O interface may further include: a positive terminal; a ground terminal; and a discharge bridge connected between the positive terminal and the ground terminal and including a current resistance smaller than a current resistance at the first switch component, to allow static electricity from the I/O terminal to be discharged through the discharge bridge. Therefore, when a large quantity of electrostatic charges are gathered on the I/O terminal, a current is discharged through the discharge bridge.

In some embodiments, the discharge bridge may include a first unilateral conductive element connected between the I/O terminal and the positive terminal and a second unilateral conductive element connected between the I/O terminal and the ground terminal, where the first unilateral conductive element is configured to allow a current to flow only from the I/O terminal to the positive terminal, and the second unilateral conductive element is configured to allow a current to flow only from the ground terminal to the I/O terminal. Therefore, electrostatic charges on the I/O terminal can be discharged through a simplified discharge bridge structure.

In some embodiments, the first unilateral conductive element and the second unilateral conductive element each may include a diode or a MOS transistor.

In some embodiments, the I/O interface may further include a clamping circuit arranged between the positive terminal and the ground terminal. In this way, discharge from the I/O terminal can be absorbed by the clamping circuit.

According to a second aspect of the present disclosure, a signal amplifier is provided, including the I/O interface according to the first aspect. The amplifier according to embodiments of this disclosure has good anti-noise performance.

According to a third aspect of the present disclosure, an integrated circuit is provided, including the I/O interface according to the first aspect.

It should be understood that the content described in the summary is not intended to limit a key or important feature of the present disclosure, and is not intended to limit the scope of the present disclosure. The following descriptions facilitate understanding of other features of the present disclosure.

### BRIEF DESCRIPTION OF DRAWINGS

The foregoing and other objects, features, and advantages of embodiments of the present disclosure become easily understood by reading the following detailed descriptions with reference to the accompanying drawings. In the accompanying drawings, several embodiments of the present disclosure are shown by way of example but not limitation.
FIG. 1 is a schematic of a circuit of an example I/O interface according to a first embodiment of the present disclosure;
FIG. 2 is a schematic of a circuit of an example I/O interface according to a second embodiment of the present disclosure;
FIG. 3 is a diagram of increasing of a withstand voltage of a switch component of an example I/O interface according to a third embodiment of the present disclosure; and
FIG. 4 is a schematic of a circuit of an example I/O interface according to a fourth embodiment of the present disclosure.

Throughout all the accompanying drawings, same or similar reference numerals represent same or similar components.

### DESCRIPTION OF EMBODIMENTS

The following describes the principle and spirit of this disclosure with reference to several example embodiments shown in the accompanying drawings. It should be understood that these specific embodiments are described merely to enable a person skilled in the art to better understand and implement this disclosure, but are not intended to limit the scope of this disclosure in any manner. In the following descriptions and claims, unless otherwise defined, all technical and scientific terms used in this specification have meanings as those commonly understood by a person of ordinary skill in the art to which the present disclosure belongs.

As used in this specification, the term "include" and similar terms should be understood as open inclusion, that is, "include but are not limited to". The term "based on" should be understood as "at least partially based on". The term "one embodiment" or "this embodiment" should be understood as "at least one embodiment". Terms such as "first", "second", and the like may refer to different objects or a same object, and are merely used to distinguish between specified objects, but do not imply a specific spatial order, a time order, an importance order, or the like of the specified objects.

In an application scenario of an integrated circuit, the integrated circuit usually includes an I/O interface, and may receive a signal from an external device through the I/O interface, to further process the signal correspondingly, so as to implement various functions. For example, in some high-speed radio frequency application scenarios (for example, 6 GHz), the integrated circuit may include a signal amplifier. A communication signal received through an antenna may be input to the signal amplifier through an I/O interface of the signal amplifier. The signal amplifier may read the communication signal, amplify the communication signal, and then output the amplified signal. The signal amplifier may include a gate component. The gate component may include a MOS transistor, and the MOS transistor is controlled to read a signal. It should be noted that, although the signal amplifier is used as an example to describe an application scenario of the I/O interface in embodiments of the present disclosure, this is merely an example, and the I/O interface in embodiments of the present disclosure may be used in any other integrated circuit, chip, or semiconductor apparatus.

As described above, with evolution of a MOS transistor process, a gate oxide layer of the MOS transistor is continuously reduced. For example, for a fin MOS transistor, a gate oxide layer of the MOS transistor is reduced to 0.8 V. In addition, electrostatic charges are gathered on an I/O terminal pad of the I/O interface during use. Discharge of the gathered electrostatic charges increases a risk of damage to the MOS transistor. In view of this, embodiments of the present disclosure provide an I/O interface, to provide electrostatic discharge protection between a gate component and an I/O terminal pad, so as to avoid damage, caused by discharge of static electricity from the I/O terminal pad through the gate component, to the gate component.

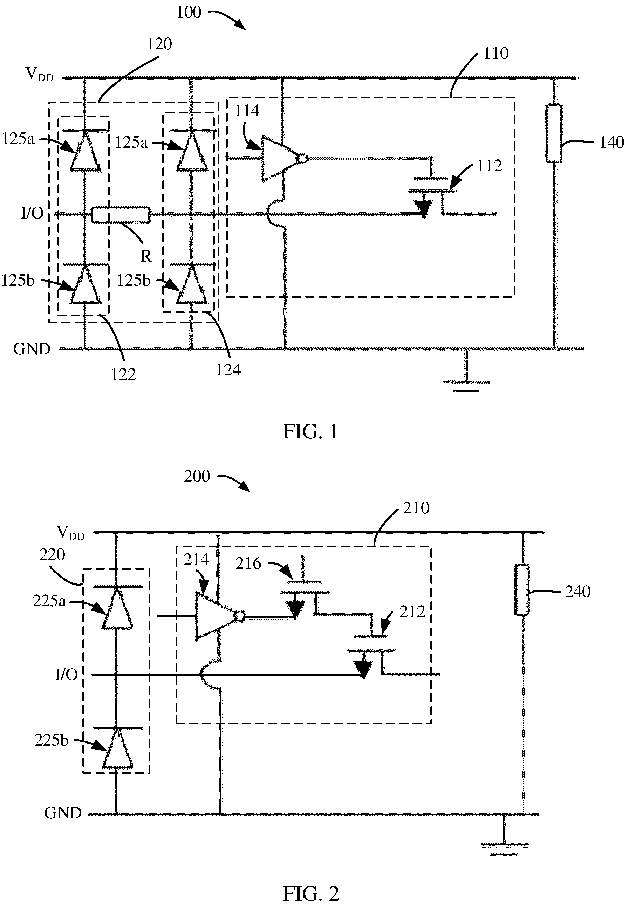

FIG. 1 is a schematic of a circuit of an example I/O interface 100 according to a first embodiment of the present disclosure. As shown in FIG. 1, the I/O interface 100 includes an I/O terminal, a positive terminal VDD, and a ground terminal GND. The positive terminal VDD and the ground terminal GND may be connected to a positive electrode and a negative electrode of a direct current voltage, and are configured to supply power to the I/O interface 100. The I/O terminal may be adapted to receive an external signal. The I/O interface 100 may further include a gate component 110. The gate component 110 may be configured to control reading of data from the I/O terminal. In some embodiments, the gate component 110 may include a first switch component 112, and the first switch component 112 may receive a control instruction to selectively read a signal from the I/O terminal. In the embodiment shown in the figure, in an example, the first switch component 112 is shown as a P MOS transistor. This is merely an example. Any other type of MOS transistor may be selected as the first switch component 112. In some embodiments, the gate component 110 further includes a phase inverter 114 connected to an input end of the first switch component. The phase inverter 114 may conveniently and flexibly control on and off of the first switch component 112 based on a requirement. In some embodiments, the input end of the first switch component 112 may include a source electrode or a drain electrode of the MOS transistor.

The gate component 110 may implement input/output control for the I/O terminal through the first switch component 112 and the phase inverter 114. For example, in some cases, an input end of the phase inverter 114 may be connected to a controller of the I/O interface 100 and may receive an instruction from the controller, and an output end of the phase inverter 114 may be connected to a gate electrode of the first switch component 112, so that the first switch component 112 may be turned on and off under control of an instruction of the phase inverter 114.

As shown in FIG. 1, the I/O interface 100 may further include a discharge bridge 120. The discharge bridge 120 is connected between the positive terminal VDD and the ground terminal GND, and the discharge bridge 120 may include two-stage discharge branches 122 and 124 and a discharge resistor R connected in series between the two-stage discharge branches. As shown in FIG. 1, the discharge branch 122 may include a first diode 125a connected between the I/O terminal and the positive terminal VDD and a second diode 125b connected between the I/O terminal and the ground terminal. The first diode 125a is configured to allow a current to flow only from the I/O terminal to the positive terminal, and the second diode 125b is configured to allow a current to flow only from the ground terminal to the I/O terminal.

An electrostatic discharge protection principle of the I/O interface 100 shown in FIG. 1 is as follows. When a large quantity of electrostatic charges are gathered on the I/O terminal to a specific extent, the electrostatic charges are discharged through a circuit of the I/O interface 100. Because a current is discharged in a path with a minimum resistance, when the I/O terminal performs discharge through the circuit of the I/O interface 100, the current is discharged through the first-stage discharge branch 122 and the second-stage discharge branch 124 of the discharge bridge 120.

The resistor R is connected in series between the first-stage discharge branch 122 and the first-stage discharge branch 124. The resistor R performs voltage division on the current, and after the voltage division by R, the current is discharged through the second-stage discharge branch 124. By using the first-stage discharge branch 122 and the first-stage discharge branch 124, it can be ensured that the electrostatic discharge circuit bypasses the first switch component 112 and flows into the VDD branch, and does not flow into the first switch component 112. In addition, by disposing the resistor R, a voltage withstood by the first switch component 112 of the gate component 110 is reduced, thereby effectively avoiding damage, caused by electrostatic discharge on the I/O terminal, to the first switch component 112.

In some embodiments, as shown in FIG. 1, the I/O interface 100 may further include a clamping circuit 140 arranged between the positive terminal VDD and the ground terminal GND. The clamping circuit may be configured to absorb electrostatic discharge from the I/O terminal to effectively protect components of the I/O interface. The clamping circuit 140 is a clamping circuit well known in the art, and a form of the clamping circuit 140 is not limited, as long as electric potential clamping can be implemented.

The disposing of the resistor R reduces the voltage withstood by the first switch component 112 of the gate component 110, but degrades performance of a system including the I/O interface. Particularly, existence of the R resistor increases a noise of the system and increases power consumption of the system.

FIG. 2 is a schematic of a circuit of an example I/O interface 200 according to a second embodiment of the present disclosure. As shown in FIG. 2, the I/O interface 200 includes an I/O terminal, a positive terminal VDD, and a ground terminal GND. The positive terminal VDD and the ground terminal GND may be connected to a positive electrode and a negative electrode of a direct current voltage, and are configured to supply power to the I/O interface 200. The I/O terminal may be adapted to receive an external signal. The I/O interface 200 may further include a gate component 210. The gate component 210 may be configured to control reading of data from the I/O terminal.

In some embodiments, the gate component 210 may include a first switch component 212, and the first switch component 212 may receive a control instruction to selectively read a signal from the I/O terminal. In the embodiment shown in the figure, in an example, the first switch component 212 is shown as a P MOS transistor. This is merely an example. Any other type of MOS transistor may be selected as the first switch component 212.

As shown in FIG. 2, an input end of the first switch component 212 is directly connected to the I/O terminal. Different from the embodiment shown in FIG. 1, the input end of the first switch component 212 is directly connected to the I/O terminal, and no additional resistor is disposed, thereby avoiding system noise caused by existence of the R resistor. This greatly improves performance of processing a radio frequency signal (for example, a 6G communication signal).

As shown in FIG. 2, the gate component 210 further includes a phase inverter 214. The phase inverter 214 may conveniently and flexibly control on and off of the first switch component 212 based on a requirement. As shown in FIG. 2, the gate component 210 may further include an anti-electrostatic discharge apparatus. The anti-electrostatic discharge apparatus may be configured to increase a breakdown voltage at the first switch component 212. The anti-electrostatic discharge apparatus may be connected in series on a branch in which the first switch component 212 and the phase inverter 214 are located. By using the anti-electrostatic discharge apparatus, a capability of the first switch component 212 to withstand an electrostatic discharge breakdown voltage of the I/O terminal can be enhanced, thereby significantly improving an electrostatic discharge protection capability of the gate component 210.

In some embodiments, the anti-electrostatic discharge apparatus may include a second switch component 216. An output end of the second switch component 216 is connected to a gate electrode of the first switch component 212. An input end of the second switch component 216 may be connected to an output end of the phase inverter 214. In this way, an electrostatic discharge protection capability of the gate component 210 may be improved by disposing the second switch component 216. In addition, because the anti-electrostatic discharge apparatus is implemented by using the second switch component 216, an on/off state of the first switch component 212 may be conveniently controlled through synchronous control of the second switch component 216 and the phase inverter 214.

In some embodiments, the gate component 210 may implement input/output control for the I/O terminal through the first switch component 212, the second switch component 216, and the phase inverter 214. For example, in some cases, an input end of the phase inverter 214 may be connected to a controller of the I/O interface 200 and may receive an instruction from the controller, the output end of the phase inverter 214 may be connected to the input end of the second switch component 216, and the output end of the second switch component 216 may be connected to the gate electrode of the first switch component 212. A gate electrode of the second switch component 216 may also receive the controller of the I/O interface 200 and may receive the instruction from the controller, to implement joint control of the phase inverter 214 and the second switch component 216. Therefore, the phase inverter 214 and the second switch component 216 are jointly (specially, synchronously) controlled, to ensure that the first switch component 212 is on and off in response to control of an instruction of the phase inverter 214 and the second switch component 216.

It should be noted that, although in the embodiment of FIG. 2, the second switch component 216 is shown as a switch component of a same type as the first switch component 212 (namely, a P MOS transistor), this is merely an example, and the second switch component 216 may be implemented as any other appropriate switch component, as long as joint control of the phase inverter 214 and the second switch component 216 can be implemented. An output end of the first switch component 212 may include a source electrode or a drain electrode of a MOS transistor. The output end of the second switch component 216 may include a source electrode or a drain electrode of a MOS transistor.

As shown in FIG. 2, the I/O interface 200 may further include a discharge bridge 220. The discharge bridge 220 is connected between the positive terminal VDD and the ground terminal GND, and the discharge bridge 220 may include a single-stage discharge branch. As shown in FIG. 2, the discharge branch may include a first diode 225a connected between the I/O terminal and the positive terminal VDD and a second diode 225b connected between the I/O terminal and the ground terminal. The first diode 225a is configured to allow a current to flow only from the I/O terminal to the positive terminal, and the second diode 225b is configured to allow a current to flow only from the ground terminal to the I/O terminal. In comparison with the solution of the embodiment shown in FIG. 1, a second-stage discharge branch is omitted, thereby further improving noise performance of a circuit. In addition, a quantity of parts is reduced, thereby further reducing costs of the circuit.

An electrostatic discharge protection principle of the I/O interface 200 shown in FIG. 2 is as follows. When a large quantity of electrostatic charges are gathered on the I/O terminal to a specific extent, the electrostatic charges are discharged through a circuit of the I/O interface 200. Because a current is discharged in a path of a minimum resistance, when the I/O terminal performs discharge through the circuit of the I/O interface 200, the current is discharged through the discharge branch of the discharge bridge 220 instead of the gate component 410, thereby avoiding damage to the gate component.

In this case, the I/O terminal is directly connected to the input end of the first switch component 212 and exposed to an electrostatic load on the I/O terminal. Because the gate component 210 may increase the breakdown voltage at the first switch component 212 through the second switch component 216 that is additionally disposed, the first switch component 212 is not damaged due to breakdown caused by electrostatic discharge of the I/O terminal.

In some embodiments, as shown in FIG. 2, the I/O interface 200 may further include a clamping circuit 240 arranged between the positive terminal VDD and the ground terminal GND. The clamping circuit 240 may be configured to absorb electrostatic discharge from the I/O terminal to effectively protect components of the I/O interface. The clamping circuit 240 is a clamping circuit well known in the art, and a form of the clamping circuit 240 is not limited, as long as electric potential clamping can be implemented.

It should be noted that, although in the embodiment shown in the figure, only one second switch component 216 is shown on a control branch of the first switch component 212 of the gate component 210, this is merely an example, and a plurality of second switch components 216 may be disposed based on a requirement, to further enhance a capability of the first switch component 212 to withstand an electrostatic discharge voltage.

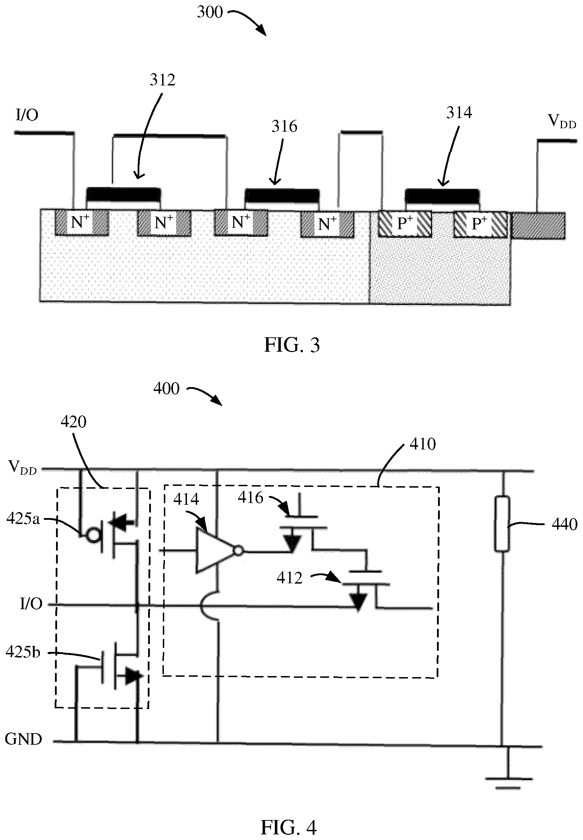

FIG. 3 is a diagram of increasing of a withstand voltage of a switch component of an example I/O 300 according to a third embodiment of the present disclosure. A sectional view shown in FIG. 3 is a diagram of increasing of a voltage on a branch circuit from an I/O terminal to a positive terminal VDD.

As shown in FIG. 3, a gate component 310 includes a first switch component 312, a second switch component 316, and a phase inverter 314 that are sequentially arranged in series from the I/O terminal to the positive terminal VDD. In the embodiment shown in the figure, the first switch component 312 and the second switch component 316 are shown as N MOS transistors. This is merely an example.

As shown in FIG. 3, if an electrostatic voltage gathered on the I/O terminal is to break down the first switch component 312, the voltage needs to sequentially break down a first NP node of the first switch component 312 (namely, an NP node by the left of the first switch component 312 in the figure), a first NP node of the second switch component 316 (namely, an NP node by the left of the second switch component 316 in the figure), a second NP node of the second switch component 316 (namely, an NP node by the right of the second switch component 316 in the figure), a first PN node of the phase inverter 314 (namely, an NP node by the right of the phase inverter 314 in the figure), and the first PN node of the phase inverter 314 (namely, an NP node by the right of the phase inverter 314 in the figure), to reach the power supply terminal VDD. The second switch component 316 is provided, so that a capability of the gate component 310 (especially the first switch component 312) to withstand an electrostatic discharge voltage can be significantly enhanced.

FIG. 4 is a schematic of a circuit of an example I/O interface 400 according to a fourth embodiment of the present disclosure. As shown in FIG. 4, the I/O interface 400 includes an I/O terminal, a positive terminal VDD, and a ground terminal GND. The positive terminal VDD and the ground terminal GND may be connected to a positive electrode and a negative electrode of a direct current voltage, and are configured to supply power to the I/O interface 400. The I/O terminal may be adapted to receive an external signal. The I/O interface 400 may further include a gate component 410. The gate component 410 may be configured to control reading of data from the I/O terminal.

In some embodiments, the gate component 410 may include a first switch component 412, and the first switch component 412 may receive a control instruction to selectively read a signal from the I/O terminal. An input end of the first switch component 412 is directly connected to the I/O terminal. The gate component 410 may further include a phase inverter 414. The phase inverter 414 may conveniently and flexibly control on and off of the first switch component 412 based on a requirement.

As shown in FIG. 4, the gate component 410 may further include an anti-electrostatic discharge apparatus. The anti-electrostatic discharge apparatus may include a second switch component 416. An output end of the second switch component 416 is connected to a gate electrode of the first switch component 412. An input end of the second switch component 416 may be connected to an output end of the phase inverter 414. In this way, an electrostatic discharge protection capability of the gate component 410 may be improved by disposing the second switch component 416. In addition, because the anti-electrostatic discharge apparatus is implemented by using the second switch component 416, an on/off state of the first switch component 412 may be conveniently controlled through synchronous control of the second switch component 416 and the phase inverter 414.

In some embodiments, the gate component 410 may implement input/output control for the I/O terminal through the first switch component 412, the second switch component 416, and the phase inverter 414. For example, in some cases, an input end of the phase inverter 414 may be connected to a controller of the I/O interface 400 and may receive an instruction from the controller, the output end of the phase inverter 414 may be connected to the input end of the second switch component 416, and the output end of the second switch component 416 may be connected to the gate electrode of the first switch component 412. A gate electrode of the second switch component 416 may also receive the controller of the I/O interface 400 and may receive the instruction from the controller, to implement joint control of the phase inverter 414 and the second switch component 416. In this way, the phase inverter 414 and the second switch component 416 are jointly (specially, synchronously) controlled, to ensure that the first switch component 412 is on and off in response to control of an instruction of the phase inverter 414 and the second switch component 416.

As shown in FIG. 4, the I/O interface 400 may further include a discharge bridge 420. The discharge bridge 220 is connected between the positive terminal VDD and the ground terminal GND, and the discharge bridge 420 may include a single-stage discharge branch. As shown in FIG. 4, the discharge branch 412 may include a first MOS transistor 425a connected between the I/O terminal and the positive terminal VDD and a second MOS transistor 425b connected between the I/O terminal and the ground terminal. The first MOS transistor 425a is configured to allow a current to flow only from the I/O terminal to the positive terminal, and the second MOS transistor 425b is configured to allow a current to flow only from the ground terminal to the I/O terminal. In comparison with the solution of the embodiment shown in FIG. 1, a second-stage discharge branch is omitted, thereby further improving noise performance of a circuit. In addition, a quantity of parts is reduced, thereby further reducing costs of the circuit. It should be noted that, in the embodiment shown in the figure, a switch component of the discharge branch is shown as the MOS transistor. This is merely an example. In embodiments of the present disclosure, any other appropriate unidirectional switch component may be used to form an electrostatic discharge path.

An electrostatic discharge protection principle of the I/O interface 400 shown in FIG. 4 is as follows. When a large quantity of electrostatic charges are gathered on the I/O terminal to a specific extent, the electrostatic charges are discharged through a circuit of the I/O interface 400. Because a current is discharged in a path of a minimum resistance, when the I/O terminal performs discharge through the circuit of the I/O interface 400, the current is discharged through the discharge branch of the discharge bridge 220 instead of the gate component 410, thereby avoiding damage to the gate component. Particularly, the I/O terminal is directly connected to the input end of the first switch component 412 and exposed to an electrostatic load on the I/O terminal. Because the gate component 410 may increase the breakdown voltage at the first switch component 412 through the second switch component 416 that is additionally disposed, the first switch component 412 is not damaged due to breakdown caused by electrostatic discharge of the I/O terminal.

As shown in FIG. 4, the I/O interface 400 may further include a clamping circuit 240 arranged between the positive terminal VDD and the ground terminal GND. The clamping circuit 240 may be configured to absorb electrostatic discharge from the I/O terminal to effectively protect components of the I/O interface. The clamping circuit 240 is a clamping circuit well known in the art, and a form of the clamping circuit 240 is not limited, as long as electric potential clamping can be implemented.

According to an embodiment of the present disclosure, a signal amplifier is further provided, including the I/O interface according to any of the preceding aspects. An anti-electrostatic discharge apparatus (especially a second switch component) is disposed, thereby effectively avoiding damage, caused by electrostatic discharge of an I/O terminal of an I/O interface, to functional components of the signal amplifier, and significantly enhancing a circuit noise of the signal amplifier, to improve noise performance of the amplifier. It should be noted that although an application case of the I/O interface according to embodiments of the present disclosure is described by using a signal amplifier as an example, the I/O in this application may be applied to another integrated circuit or chip.

According to an embodiment of the present disclosure, an integrated circuit is further provided, including the I/O interface according to any of the preceding aspects. The integrated circuit according to this embodiment of the present disclosure can effectively avoid damage, caused by electrostatic discharge of an I/O terminal of an I/O interface, to functional components of the integrated circuit.

In addition, although the operations are described in a particular order, this should not be understood as requiring the operations to be completed in the particular order shown or in a sequential order, or performing all of the illustrated operations to obtain a desired result. In some cases, multitasking or parallel processing is beneficial. Similarly, while the foregoing descriptions include some specific implementation details, this should not be construed as limitations on the scope of any invention or claims, but rather as descriptions of specific embodiments that may be specific to a specific invention. Some features described in this specification in the context of separate embodiments may alternatively be integrated into a single embodiment. Conversely, various features that are described in the context of a single embodiment may alternatively be implemented separately in a plurality of embodiments or in any suitable sub-combination.

Although the subject matter has been described in language specific to structure features and/or methodological actions, it should be understood that the subject matter defined in the appended claims is not limited to the specific features or actions described above. Rather, the specific features and actions described above are disclosed as example forms of implementing the claims.

## Claims

1. An input/output I/O interface, comprising:
an I/O terminal; and
a gate component, configured to control reading of data from the I/O terminal, and comprising:
a first switch component, wherein an input end of the first switch component is connected to the I/O terminal; and
an anti-electrostatic discharge apparatus, configured to increase a breakdown voltage at the first switch component.

2. The I/O interface according to claim 1, wherein the input end of the first switch component is directly connected to the I/O terminal.

3. The I/O interface according to claim 1, wherein the anti-electrostatic discharge apparatus comprises a second switch component, and an output end of the second switch component is connected to a gate electrode of the first switch component.

4. The I/O interface according to claim 3, wherein the gate component further comprises a phase inverter connected to an input end of the second switch component.

5. The I/O interface according to claim 4, wherein a gate electrode of the second switch component and an input end of the phase inverter are synchronously controlled.

6. The I/O interface according to any one of claims 3 to 5, wherein the first switch component and the second switch component each comprise a MOS FET.

7. The I/O interface according to any one of claims 2 to 5, wherein the first switch component comprises a MOS transistor, and the input end comprises a source electrode or a drain electrode of the MOS transistor.

8. The I/O interface according to any one of claims 3 to 5, wherein the second switch component comprises a MOS transistor, and the output end comprises a source electrode or a drain electrode of the MOS transistor.

9. The I/O interface according to any one of claims 1 to 4, further comprising:
a positive terminal;
a ground terminal; and
a discharge bridge, connected between the positive terminal and the ground terminal, and comprising a current resistance smaller than a current resistance at the first switch component, to allow static electricity from the I/O terminal to be discharged through the discharge bridge.

10. The I/O interface according to claim 9, wherein the discharge bridge comprises a first unilateral conductive element connected between the I/O terminal and the positive terminal and a second unilateral conductive element connected between the I/O terminal and the ground terminal, wherein the first unilateral conductive element is configured to allow a current to flow only from the I/O terminal to the positive terminal, and the second unilateral conductive element is configured to allow a current to flow only from the ground terminal to the I/O terminal.

11. The I/O interface according to claim 10, wherein the first unilateral conductive element and the second unilateral conductive element each comprise a diode or a MOS transistor.

12. The I/O interface according to claim 9, further comprising a clamping circuit arranged between the positive terminal and the ground terminal.

13. A signal amplifier, comprising the I/O interface according to any one of claims 1 to 12.

14. An integrated circuit, comprising the I/O interface according to any one of claims 1 to 12.
